Europäisches Patentamt

European Patent Office

Office européen des brevets

(11) Numéro de publication: **0 347 996**
**A2**

(12) # DEMANDE DE BREVET EUROPEEN

(21) Numéro de dépôt: 89201598.3

(22) Date de dépôt: 19.06.89

(51) Int. Cl.⁴: **H01J 43/24 , H01J 1/88 ,**
**H05K 7/12 , //F16B17/00**

(30) Priorité: 24.06.88 FR 8808501

(43) Date de publication de la demande:
27.12.89 Bulletin 89/52

(84) Etats contractants désignés:
CH DE FR GB LI

(71) Demandeur: RTC-COMPELEC
117, quai du Président Roosevelt
F-92130 Issy les Moulineaux(FR)
(84) FR

Demandeur: N.V. Philips'
Gloeilampenfabrieken
Groenewoudseweg 1
NL-5621 BA Eindhoven(NL)
(84) CH DE GB LI

(72) Inventeur: Chopy, Hervé
Société Civile S.P.I.D. 209, rue de l'université
F-75007 Paris(FR)

(74) Mandataire: Charpail, François et al
Société Civile S.P.I.D. 209, rue de l'Université
F-75007 Paris(FR)

(54) **Tube photomultiplicateur comportant des électrodes fixées sur un support.**

(57) Tube photomultiplicateur comprenant une pluralité d'électrodes devant être fixées par des pattes (10) de fixation à l'intérieur d'une fente (20). Selon l'invention, chaque patte (10) de fixation est fixée de manière serrée à l'intérieur de la fente (20), et, en particulier, chaque fente (20) comprend, d'une part, deux extrémités (22a,22b) de profil continûment variable, en contact avec des bords (21a,21b) de la patte (10) de fixation situés sur une première face (11) de ladite patte, et, d'autre part, au moins un méplat (23) de support central en contact avec une deuxième face (12) de la patte (10) de fixation, la patte (10) de fixation présentant à sa base des arrondis coopérant respectivement avec les profils desdites extrémités (22a,22b) de la fente (20).

Application aux tubes photomultiplicateurs dont les dynodes présentent des pattes de fixation.

FIG. 2

## TUBE PHOTOMULTIPLICATEUR COMPORTANT DES ELECTRODES FIXEES SUR UN SUPPORT.

La présente invention concerne un tube photomultiplicateur d'électrons présentant, d'une part, des supports pourvus d'une pluralité de fentes, et, d'autre part, une pluralité d'électrodes fixées aux supports par des pattes de fixation disposées, chacune, a l'intérieur d'une fente respective.

L'invention trouve une application particulièrement avantageuse dans le domaine des tubes photomultiplicateurs lorsqu'on doit maintenir des pattes de dynodes dans des fentes aménagées dans des plaquettes isolantes faisant également office d'entretoises.

On connaît, de façon usuelle, des tubes photomultiplicateurs conformes au préambule comportant divers dispositifs de maintien comme le dispositif constitué par une fente étroite et une patte dont l'extrémité est repliée après avoir été insérée dans la fente. Il faut également citer le dispositif constitué, à l'inverse, d'une fente large, coopérant avec un bossage réalisé sur la patte dont l'extrémité peut aussi être repliée si on le désire.

Toutefois, les dispositifs de maintien connus de l'état de la technique présentent tous des inconvénients. Le dispositif à fente étroite est difficile et coûteux à réaliser; il est, de plus, de mise en oeuvre malaisée dans la mesure où l'introduction d'une patte dans une fente étroite est une opération délicate pour la personne qui est chargée de l'effectuer. D'autre part, si une fente large est de réalisation plus facile, car plus tolérante, elle nécessite néanmoins une mise en forme particulière de ladite patte, comme l'élaboration d'un bossage qui augmente le prix de revient du dispositif de maintien. De plus, dans les deux exemples décrits ci-dessus, le repliage de l'extrémité de la patte, après introduction, contribue à rendre plus complexe, et donc plus onéreuse, l'utilisation des dispositifs connus. Enfin, il convient également d'éviter tout mouvement de vibrations des dynodes qui ont pour conséquence de provoquer un effet microphonique.

Aussi, le problème technique à résoudre par l'objet de la présente invention est de proposer un tube photomultiplicateur conforme au préambule dont le maintien des pattes d'électrodes dans les fentes de support serait de réalisation facile et bon marché, de mise en oeuvre aisée, et qui assurerait un maintien positif et sûr de la patte dans la fente de façon à empêcher les vibrations des électrodes.

La solution au problème technique posé consiste, selon la présente invention, en ce que chaque patte de fixation est fixée de manière serrée à l'intérieur de la fente respective.

Ce type de fixation n'exige aucune mise en forme particulière de la patte mettant en oeuvre un outil spécial. Elle ne nécessite pas davantage d'opération supplémentaire du type repliage. Enfin, la fixation étant serrée, il ne peut se produire aucun mouvement intempestif de la patte dans la fente du support.

Dans un mode de réalisation avantageux de l'invention, il est prévu que chaque fente comprend, d'une part, deux extrémités de profil continûment variable, en contact avec des bords de la patte de fixation situés sur une première face de ladite patte, et, d'autre part, au moins un méplat de support central en contact avec une deuxième face de la patte de fixation, et en ce que la patte de fixation présente à sa base des arrondis coopérant respectivement avec les profils desdites extrémités de la fente. Dans ce mode particulier d'exécution, la fixation serrée est assurée par la coopération desdits profils d'extrémités variables avec les arrondis de la base de la patte. Comme on le verra en détail plus loin, quelles que soient les dispersions de dimensions de la patte de fixation et de la fente, il existe en général une profondeur d'enfoncement de la patte dans la fente pour laquelle ladite patte vient parfaitement en appui contre la fente.

Si la patte doit être enfoncée davantage dans la fente, il peut se produire que la largeur de patte en contact avec la fente soit supérieure à la plus grande largeur de fente. Il se produit alors une flexion de la patte. De façon à permettre cet arc-boutement, on envisage que la fente présente un évidement central du côté de la première surface de la patte de fixation, opposé au méplat de support central. Un avantage essentiel de cette disposition est d'obtenir une fente élargie grâce audit évidement, équivalente à une fente étroite, mais de réalisation beaucoup plus aisée et moins coûteuse. Afin de renforcer encore cet avantage, on prévoit que la fente présente deux évidements d'extrémité du côté de la deuxième surface de la patte de fixation, opposés respectivement aux profils des extrémités.

De façon à permettre l'introduction de la patte entre les méplats d'extrémité et le méplat central, il est prévu que l'extrémité entrante de la patte de fixation comporte des moyens de biseautage, et que l'évidement central a une largeur au moins égale à la largeur de ladite extrémité entrante. La mise en place de la patte dans la fente "équivalente" s'effectue donc, d'abord, en faisant pénétrer ladite patte dans l'évidement central, puis, dans un deuxième temps, en amenant, légèrement à force, la patte entre les méplats d'extrémité et central. L'introduction de la patte dans l'évidement central est facilitée par la présence desdits moyens de biseautage, ce qui, sur le plan industriel, permet un grand gain de temps et un montage très sûr.

La description qui va suivre en regard des dessins annexés, donnés à titre d'exemples non limitatifs, fera bien comprendre en quoi consiste l'invention et comment elle peut être réalisée.

La figure 1 est une vue en coupe d'un tube photomultiplicateur selon l'invention.

La figure 2 est une vue de face d'un ensemble patte de fixation-fente du tube photomultiplicateur de la figure 1.

La figure 3 est une vue de dessus correspondant à la vue de face de la figure 2.

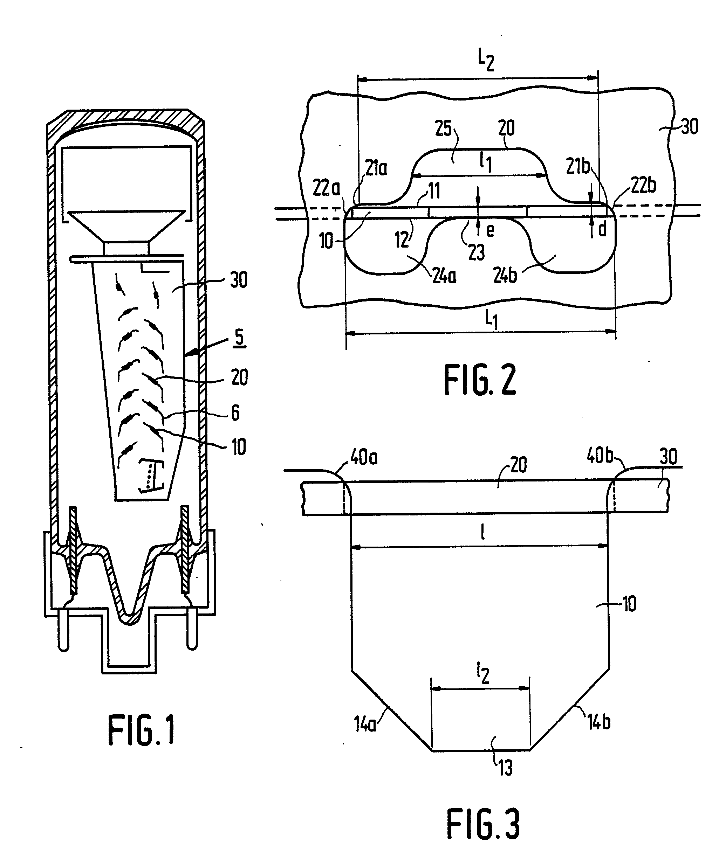

La figure 1 montre, en coupe, un tube photomultiplicateur d'un type classique, comprenant notamment un multiplicateur 5 d'électrons. Dans l'exemple de la figure 1, le multiplicateur 5 présente deux supports 30 ayant la forme de plaquettes isolantes placées parallèlement l'une par rapport à l'autre. Les supports 30 disposent d'une pluralité de fentes 20 destinée à recevoir les pattes 10 de fixation d'électrodes 6 constituant les dynodes du multiplicateur 5. Les figures 2 et 3 donnent, en vue de face et en vue de dessus, le détail d'un ensemble patte de fixation 10-fente 20.

Comme l'indiquent les figures 2 et 3, la patte de fixation 10 est maintenue de manière serrée à l'intérieur de la fente 20. Plus particulièrement, la fente 20 comprend deux extrémités 22a, 22b de profil continûment variable, ici de forme arrondie, en contact avec les bords 21a, 21b de la patte 10 de fixation situés sur une première face 11 de ladite patte. La fente 20 comprend, en outre, un méplat 23 de support central en contact avec une deuxième face 12 de la patte 10 de fixation. De plus, comme on peut le voir sur la figure 3, la patte 10 présente à sa base des arrondis 40a, 40b coopérant respectivement avec les profils desdites extrémités 22a, 22b de la fente 20. C'est de cette coopération que résulte la fixation serrée de la patte 10 dans la fente 20. En effet, dans la mesure où la largeur 1 de la patte 10 est comprise entre la largeur maximale $L_1$ de la fente 20 et la largeur $L_2$ de la fente non compris les extrémités 22a, 22b de profil variable, il existe toujours une position de la patte de fixation dans laquelle ladite patte est en contact positif avec la fente 30, et ceci en dépit de variations de tolérance dans les cotes de la patte et de la fente.

On peut voir sur la figure 2 que la fente 20 présente un évidement central 25 du côté de la première surface 11 de la patte 10 de fixation, opposé au méplat 23 de support central, ainsi que deux évidements 24a, 24b d'extrémité du côté de la deuxième surface 12 de la patte, opposés respectivement aux profils des extrémités 22a, 22b. L'évidement central 25 permet à la patte 10 de fixation de se mettre en flexion lorsqu' il est nécessaire de l'engager au-delà de sa position de simple contact avec la fente 20. D'autre part, l'ensemble des évidements 25, 24a, 24b a également pour avantage de faciliter la réalisation de la fente 20 en augmentant ses dimensions tout en maintenant la fente "équivalente" aussi étroite que l'on veut. La mise en forme d'une fente large est en effet plus aisée et moins chère que celle d'une fente étroite; à titre d'exemple, on peut envisager de réaliser des entretoises de dynodes par moulage-pressage d'une plaquette d'alumine et conformation de la fente à l'aide d'un outil approprié.

L'évidement central 25 est également utile au moment de l'introduction de la patte 10 dans la fente 20. Il sert en effet de guide à l'extrémité entrante 13 de la patte 10 lorsqu'elle est munie de moyens 14a, 14b de biseautage (figure 3), et à condition que sa largeur l1 soit au moins égale à la largeur l2 de l'extrémité entrante 13. Les moyens de biseautage montrés à la figure 3 sont deux pans coupés, mais ils pourraient avoir toute autre forme équivalente, comme par exemple un arrondi.

## Revendications

1. Tube photomultiplicateur comprenant un multiplicateur (5) d'électrons présentant, d'une part, des supports (30) pourvus d'une pluralité de fentes (20), et, d'autre part, une pluralité d'électrodes (6) fixées aux supports (30) par des pattes (10) de fixation disposées, chacune, à l'intérieur d'une fente respective (20), caractérisé en ce que chaque patte (10) de fixation est fixée de manière serrée à l'intérieur de la fente respective (20).

2. Tube photomultiplicateur selon la revendication 1, caractérisé en ce que chaque fente (20) comprend, d'une part, deux extrémités (22a, 22b) de profil continûment variable, en contact avec des bords (21a, 21b) de la patte (10) de fixation situés sur une première face (11) de ladite patte, et, d'autre part, au moins un méplat (23) de support central en contact avec une deuxième face (12) de la patte (10) de fixation, et en ce que la patte (10) de fixation présente à sa base des arrondis (40a, 40b) coopérant respectivement avec les profils desdites extrémités (22a, 22b) de la fente (20).

3. Tube photomultiplicateur selon la revendication 2, caractérisé en ce que la fente (20) présente un évidement central (25) du côté de la première surface (11) de la patte de fixation, opposé au méplat (23) de support central.

4. Tube photomultiplicateur selon la revendication 3, caractérisé en ce que la fente (20) présente deux évidements (24a, 24b) d'extrémité du côté de la deuxième surface (12) de la patte de fixation, opposés respectivement aux profils des extrémités (22a, 22b).

5. Tube photomultiplicateur selon l'une des revendications 3 ou 4, caractérisé en ce que l'extrémité entrante (13) de la patte (10) de fixation comporte des moyens (14a, 14b) de biseautage, et en ce que l'évidement central (25) a une largeur ($l_1$) au moins égale à la largeur ($l_2$) de ladite extrémité entrante (13).

FIG.1

FIG.2

FIG.3